# EUROPÄISCHE PATENTSCHRIFT

(11) **EP 1 630 769 B1**
(45) Veröffentlichungstag und Bekanntmachung des Hinweises auf die Patenterteilung: **15.10.2008**
(21) Anmeldenummer: 04104042.9
(22) Anmeldetag: 23.08.2004
(51) Int. Cl.: G09F 3/02, G09F 3/10

(54) **Etikett zum Abdecken von Gasaustauschöffnungen**
Label for covering gas exchange openings
Etiquette pour couvrir des ouvertures d'échange de gaz

(43) Veröffentlichungstag der Anmeldung: 01.03.2006
(73) Patentinhaber: Schreiner Group GmbH & Co. KG, 85764 Oberschleissheim (DE)
(72) Erfinder: Birk, Uwe, Dr., 80995 München (DE)
(74) Vertreter: Kehl, Günther

(56) Entgegenhaltungen:
- EP-A1- 0 024 310
- EP-A1- 1 340 695
- GB-A- 1 583 503
- US-B1- 6 182 850

## Beschreibung

Die vorliegende Erfindung betrifft ein Etikett zum Abdecken von Gasaustauschöffnungen.

Elektronische Steuergeräte werden, beispielsweise im Automobilbau oder bei verfahrenstechnischen Apparaten und Maschinen, häufig in staubiger, feuchter oder korrosiver Umgebung eingesetzt. Zudem können sie mitunter mechanischen Belastungen, etwa Schlag- oder Stoßbelastungen ausgesetzt sein. Um die Funktion der enthaltenen elektronischen Bauteile sicherzustellen, werden die Steuergeräte daher in geschlossene Gehäuse eingebaut. Letztere müssen zwar gegen die genannten schädigenden Einflüsse abgedichtet sein, dennoch ist es in aller Regel erforderlich, Druckausgleichsöffnungen vorzusehen, die einen Gasaustausch mit der Umgebung zulassen. Insbesondere muß bei sinkender Umgebungstemperatur gewährleistet sein, daß Wassermoleküle aus der im Gehäuseinneren enthaltenen Luft nach außen diffundieren können, um schädliche Kondensation im Gerät zu vermeiden.

Um dennoch das Eindringen von flüssigem Wasser und Staub zu vermeiden, werden dem Druckausgleich bzw. Dampfdruckausgleich dienende Gasaustauschöffnungen zuweilen mit gasdurchlässigen Membranen verschlossen. Entsprechende Membranen können auch als selbstklebende Etiketten oder Teile davon vorgesehen werden, um eine einfache Anbringung zu ermöglichen. Ein derartiges Etikett ist beispielsweise aus der deutschen Offenlegungsschrift DE 196 53 890 A1 bekannt.

Häufig ist es jedoch nicht ausreichend, eine Gasaustauschöffnung lediglich mit einer Membran abzudecken, denn übliche Membranen bieten nur begrenzten Schutz gegen das Hindurchtreten von Flüssigkeiten. So tritt beispielsweise durch die meisten handelsüblichen Membranen Wasser hindurch, wenn der Strahl eines Hochdruckreinigers darauf gerichtet ist. Dies ist in der Praxis, beispielsweise bei Steuergeräten von Baumaschinen oder elektronischen Einrichtungen in der Verfahrenstechnik nicht ungewöhnlich. Ferner können freiliegende Membranen durch mechanischen Verschleiß undicht werden.

Aus WO 99/29150 A1 ist bekannt, eine mit einer Membran überklebte Gasaustauschöffnung in einer Vertiefung einer Gehäusewand anzubringen und die Vertiefung mit einem schützenden Aufkleber zu überkleben. Der Gasaustausch bleibt gewährleistet, indem ausgehend von der Vertiefung Ausnehmungen in der Gehäusewand vorgesehen sind, welche von dem Aufkleber nur teilweise bedeckt werden. Eine derartige Anordnung ist jedoch relativ aufwendig, da Vertiefung und Ausnehmungen durch entsprechende Formgebung bzw. Bearbeitung der Gehäusewand hergestellt werden. Bei der Verwendung selbstklebender Membranen tritt zudem das Problem auf, daß diese maschinell nicht oder nur schwierig in der Vertiefung verspendet werden können, so daß für gewöhnlich ein Einkleben von Hand erfolgen muß.

Aus US 6 182 850 B1 sind Lüftungssysteme bekannt, welche fest in den Foliendecken bzw. die Folienumhüllung einer insbesondere becherförmigen Verpackung integriert sind.

Angesichts der geschilderten Problematik liegt der vorliegenden Erfindung die Aufgabe zugrunde, eine Möglichkeit zum Abdecken von Gasaustauschöffnungen zu schaffen, welche kostengünstig umsetzbar und flexibel einsetzbar ist, und welche zudem einen hohen Schutz gegen direkt auftreffende Flüssigkeitsstrahle sowie gegen Verschleiß bietet.

Gemäß einem Aspekt der vorliegenden Erfindung wird diese Aufgabe durch ein Etikett nach Patentanspruch 1 gelöst. Bevorzugte Ausführungsformen der Erfindung können gemäß einem der Ansprüche 2 bis 14 ausgestaltet sein.

Gemäß einem weiteren Aspekt der vorliegenden Erfindung wird diese Aufgabe durch ein Verfahren nach Patentanspruch 15 gelöst. Bevorzugte Ausführungsformen des Verfahrens können gemäß einem der Ansprüche 16 bis 19 ausgestaltet sein.

Grundsätzlich kann jede im Rahmen der vorliegenden Anmeldung beschriebene bzw. angedeutete Variante der Erfindung besonders vorteilhaft sein, je nach wirtschaftlichen und technischen Bedingungen im Einzelfall. Soweit nichts gegenteiliges dargelegt ist, bzw. soweit grundsätzlich technisch realisierbar, sind einzelne Merkmale der beschriebenen Ausführungsformen austauschbar oder miteinander kombinierbar.

Ein erfindungsgemäß gestaltetes Etikett wird so über eine Gasaustauschöffnung geklebt, daß diese über die für Gas durchlässige Unterseite des Kanalsystems mit der im Etikett vorgesehenen Gasdurchtrittsöffnung verbunden ist. Die Gasaustauschöffnung kann somit als einfache Bohrung im Gehäuse oder dergleichen ausgeführt sein und wird dennoch vom Oberetikett sicher abgedeckt, ohne daß die Druckausgleichs- bzw. Dampfaustauschfunktion beeinträchtigt wäre. Besondere konstruktive Maßnahmen in der Gehäusewand sind nicht erforderlich. So lassen sich auch Druckausgleichöffnungen von Gehäusen, welche ursprünglich nicht in Hinblick auf besondere Widerstandsfähigkeit gegen direkt auftreffende Flüssigkeitsstrahle konstruiert wurden, nachträglich entsprechend ausrüsten

Bei vorgesehener selbstklebender Ausführung des Etiketts läßt sich dieses auch automatisiert problemlos anbringen. Für eine entsprechende selbstklebende Beschichtung kommen je nach Gehäusematerial und zu erwartender Beanspruchung grundsätzlich alle auf dem Gebiet der Etikettentechnik gebräuchlichen Klebstoffe in Frage. Alternativ kommen auch andere Befestigungsmöglichkeiten in betracht.

Als Material für das Oberetikett können herkömmliche, in Abhängigkeit der zu erwartenden Verschleißbeanspruchung auswählbare Folien oder Folienverbünde verwendet werden. Soll das Etikett auch noch eine Kennzeichnungsfunktion, beispielsweise als Typenschild oder Warnaufkleber, erfüllen, so kann für das Oberetikett ein an sich bekannter laserbeschriftbarer Folienverbund vorgesehen werden. Zusätzlich oder stattdessen kann das Oberetikett jedoch auch mit einem Aufdruck versehen werden. Auch andere Funktionen kann das Oberetikett übernehmen, beispielsweise kann es mit einem Sicherheitsmerkmal gegen Fälschungen ausgestattet sein, wie etwa einem Hologramm, einer Mikroschrift o.ä.

Das Unteretikett kann ebenfalls ein- oder mehrlagig ausgeführt werden. Als. Materialien kommen vor allem eine Vielzahl von Kunststoffmaterialien in Frage. Die Dicke des Unteretiketts bestimmt die Höhe der Kanäle und kann in Abhängigkeit vom erforderlichen Gasdurchsatz sowie der Breite der im Unteretikett vorgesehenen Kanäle gewählt werden. Soll das Eintreten von, insbesondere größeren, Fremdkörpern in die Kanäle vermieden werden, so kann eine geringere Dicke des Unteretiketts und somit eine geringere Kanalhöhe gewählt werden. Grundsätzlich ist die Erfindung in einem breiten Spektrum unterschiedlicher Abmessungen und Abmessungsverhältnisse ausführbar.

Gasdurchtrittsöffnungen als Verbindung zwischen Kanal und Umgebung können unterschiedlich gestaltet sein. So kann ein Kanal erfindungsgemäß bis an den Etikettenrand geführt sein und dort in die Umgebungsatmosphäre münden. Alternativ können Gasdurchtritssöffnungen auch im Oberetikett vorgesehen sein.

Kanäle im Unteretikett können Knicke oder Biegungen aufweisen, um das Vordringen von Fremkörpern zur Gasaustauschöffnung zu vermeiden oder aber um den Druckverlust strömender Flüssigkeit zu erhöhen, wenn ein Flüssigkeitstrahl oder -schwall direkt auf eine Gasdurchtrittsöffnung auftrifft. Werden mehrere miteinander verbundene Kanäle mit jeweils eigener Gasdurchtrittsöffnung vorgesehen, so ist es möglich, diese so anzuordnen, daß bei fast beliebiger Orientierung des Etiketts Flüssigkeit aus dem Kanalsystem ablaufen kann. Besonders günstig ist es dabei häufig, mindestens drei Kanäle sternförmig anzuordnen, und das Etikett dann so anzubringen, daß die zu verdeckende Gasaustauschöffnung an der Stelle liegt, an welcher die Kanäle aufeinander treffen. Für besondere Dichtungsaufgaben können Kanäle im Unteretikett labyrinthartig geführt werden.

Erfindungsgemäße Etiketten eignen sich auch zur Abdeckung von Gasaustauschöffnungen, welche bereits mit einer gaspermeablen Membran verschlossen sind. Alternativ kann das Etikett selbst gemäß einer bevorzugten Weiterbildung der Erfindung eine Membran als ganz- oder teilflächig vorgesehene Lage unterhalb des Unteretiketts aufweisen. Es sind jedoch auch Anwendungen ohne Membran denkbar, beispielsweise wenn das Etikett nur als Spritzwasserschutz dient, und die Orientierung relativ zur Schwerkraft vorgegeben ist.

Selbstverständlich kann ein einerfindungsgemäßes Etikett auch so gestaltet sein, daß es mehrere Öffnungen abdeckt.

Die Herstellung der Kanalstrukturen im Unteretikett kann vorteilhafterweise dergestalt erfolgen, daß die Kanalkonturen zunächst in durchgehendes Unteretikettenmaterial gestanzt werden, welches auf einem Trägermaterial vorliegt, und dann das Unteretikettenmaterial aus dem Inneren der Kanäle als Gitter abgezogen wird. Danach kann Oberetikettenmaterial darüberlaminiert und die Etikettenkontur gestanzt werden. Alternativ können auch Oberetiketten einzeln aufgespendet werden.

Nachfolgend werden anhand der zugehörigen Zeichnungen Beispiele bevorzugter Ausführungsformen der vorliegenden Erfindung näher erläutert. Die Zeichnungen sind dabei rein schematische und nicht maßstäbliche Darstellungen, insbesondere sind bei Schnittdarstellungen der Etiketten Schichtdicken aus Anschaulichkeitsgründen stark vergrößert. Einander entsprechende Elemente sind in den einzelnen Figuren jeweils mit denselben Bezugszeichen versehen.
- Fig. 1: zeigt ein erfindungsgemäßes, als Typenschild mit Barcode ausgeführtes Etikett in der Draufsicht, wobei die bevorzugte Lage der abzudeckenden Gasaustauschöffnung als strichlierter Kreis und die im Unteretikett vorgesehenen, bis zum Etikettenrand reichenden Kanalstrukturen als strichlierte Linien angedeutet sind.
- Fig. 2: zeigt ebenfalls ein als Typenschild mit Barcode ausgeführtes Etikett in der Draufsicht, wobei die bevorzugte Lage der abzudeckenden Gasaustauschöffnung wiederum als strichlierter Kreis und die im Unteretikett vorgesehene Kanalstruktur als strichlierte Linie angedeutet ist, und wobei im Gegensatz zu Fig. 1 die im Etikett vorgesehenen Gasdurchtrittsöffnungen als Stanzungen im Oberetikett ausgeführt sind.
- Fig. 3a: zeigt das Oberetikett eines als Hinweisschild ausgebildeten Etiketts in der Draufsicht.
- Fig. 3b: zeigt das zu dem Oberetikett aus Fig. 3a gehörende Unteretikett in der Draufsicht, wobei die bevorzugte Lage der abzudeckenden Gasaustauschöffnung wiederum als strichlierter Kreis angedeutet ist.
- Fig. 4a: zeigt das Oberetikett eines als Warnschild ausgebildeten Etiketts in der Draufsicht.
- Fig. 4b: zeigt das zu dem Oberetikett aus Fig. 4a gehörende Unteretikett in der Draufsicht, wobei die bevorzugte Lage der abzudeckenden Gasaustauschöffnung wiederum als strichlierter Kreis angedeutet ist.
- Fig. 5a: zeigt das Oberetikett eines als Typenschild ausgebildeten Etiketts in der Draufsicht.
- Fig. 5b: zeigt das zu dem Oberetikett aus Fig. 5a gehörende Unteretikett in der Draufsicht, wobei die bevorzugte Lage der abzudeckenden Gasaustauschöffnung wiederum als strichlierter Kreis angedeutet ist.
- Fig. 6a: zeigt das Oberetikett eines weiteren als Typenschild ausgebildeten Etiketts in der Draufsicht.
- Fig. 6b: zeigt das zu dem Oberetikett aus Fig. 6a gehörende Unteretikett in der Draufsicht, wobei die bevorzugte Lage der abzudeckenden Gasaustauschöffnung wiederum als strichlierter Kreis angedeutet ist.
- Fig. 7a: zeigt das Oberetikett eines weiteren Etiketts in der Draufsicht.
- Fig. 7b: zeigt das zu dem Oberetikett aus Fig. 7a gehörende Unteretikett in der Draufsicht, wobei die bevorzugte Lage der abzudeckenden Gasaustauschöffnung wiederum als strichlierter Kreis angedeutet ist.
- Fig. 8a: zeigt das Oberetikett eines weiteren als Typenschild ausgebildeten Etiketts in der Draufsicht.
- Fig. 8b: zeigt das zu dem Oberetikett aus Fig. 8a gehörende Unteretikett in der Draufsicht, wobei die bevorzugte Lage der abzudeckenden Gasaustauschöffnung wiederum als strichlierter Kreis angedeutet ist.

- Fig. 8c: zeigt eine Schnittdarstellung des bestimmungsgemäß auf einem Gehäuseteil angeordneten Etiketts aus Figuren 8a, b in der durch die strichpunktierte Linie A-A' angedeuteten Schnittebene.
- Fig. 9: zeigt eine zu Fig. 8c analoge Schnittdarstellung eines ähnlich aufgebauten Etiketts, welches jedoch als zusätzliche Etikettenlage eine Membran aufweist.
- Fig. 10a: zeigt eine zu Fig. 8b analoge Darstellung des Unteretiketts eines ähnlich aufgebauten Etiketts, welches jedoch eine Membran im Bereich der (wiederum durch den inneren strichlierten Kreis angedeuteten) bestimmungsgemäßen Lage der zu verdeckenden Gasaustauschöffnung aufweist, wobei die Position der Membran durch den äußeren der beiden strichlierten Kreise angedeutet ist.
- Fig. 10b: zeigt eine zu Fig. 8c und Fig. 9 analoge Schnittdarstellung des in Fig. 10a dargestellten Etiketts in der durch die strichpunktierte Linie B-B' angedeuteten Schnittebene.
- Fig. 11a: zeigt einen Auschnitt einer Unteretikettenmaterialbahn mit den Stanzlinien der Kanalkonturen für die Herstellung von Etiketten der in Fig. 8a-c, 9 und 10a-b dargestellten Art.
- Fig. 11b: zeigt den gleichen Ausschnitt wie in Fig. 11a nach Abziehen des Gitters, Überlaminieren einer Oberetikettenmaterialbahn und Stanzen der Etikettenkonturen, wobei die Stanzlinien in der Unteretikettenmaterialbahn strichliert angedeutet sind.

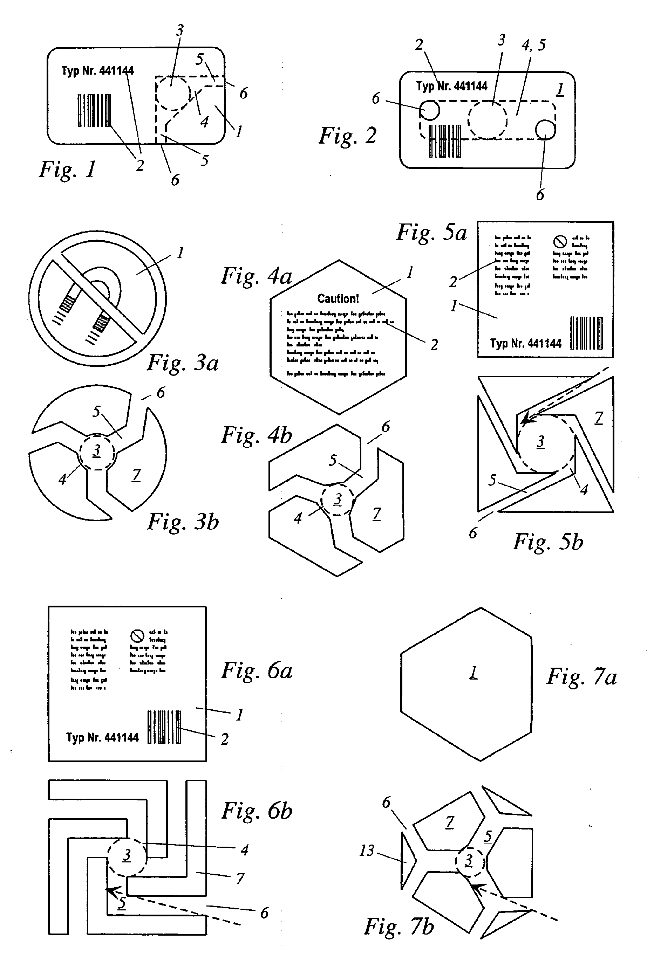

Das Oberetikett 1 des in in Fig. 1 dargestellten Etiketts ist mit einer Beschriftung 2 in Form eines Barcodes und einer Typennummer ausgestattet. Die Beschriftung 2 kann aufgedruckt sein, oder aber sie wurde mittels Laserbeschriftung erzeugt. Ein laserbeschriftbarer Folienaufbau des Oberetiketts läßt sich beispielsweise aus einer zumindest teiltransparenten Deckfolie, einer laserablatierbaren Schicht (z.B. aufgesputterte Metallisierung) und einer Kontrastschicht herstellen. Die Funktion einer Kontrastschicht kann auch das Unteretikett (in Fig. 1 verdeckt) übernehmen.

Dort, wo sich bei bestimmungsgemäßer Verwendung die abzudeckende Gasaustauschöffnung 3 befindet, ist eine Aussparung 4 im Unteretikett vorgesehen, welche sich in zwei Kanälen 5 fortsetzt. Die Kanäle 5 münden am Etikettenrand in die Umgebung, so daß durch den Schnittbereich zwischen Etikettenkontur und den Konturen des Kanalsystems zwei Gasdurchtrittsöffnungen 6 definiert sind. Dadurch, daß die Kanäle 5 in zwei verschiedene Richtungen orientiert sind, kann Flüssigkeit bei vielen verschiedenen Raumorientierungen des Gehäuses, auf welches das Etikett bestimmungsgemäß aufgeklebt wird, aus dem Kanalsystem abfließen. Vorteilhafterweise kann im Bereich der Aussparung 4 und etwas über diese hinausreichend eine gaspermeable Membran (in Fig. 1 nicht dargestellt) angeordnet sein. Die Membran kann sich auch über die gesamte Unterseite des Etiketts erstrecken. Bei untereseitig selbstklebender Ausführung muß die Membran dann im Bereich der Gasaustauschöffnung 3 weitgehend klebstofffrei sein, um ihre Gaspermeabilität zu bewahren.

Das in Fig. 2 dargestellte Etikett weist ein wie in Fig. 1 gestaltetes Oberetikett 1 auf. Die Aussparung 4 im Unteretikett (in Fig. 2 verdeckt) ist als breiter Kanal 5 gestaltet, welcher im Unterschied zu Fig. 2 nicht bis zum Etikettenrand heranreicht. Vorteilhafterweise kann wiederum im Bereich der Aussparung 4 und etwas über diese hinausreichend eine gaspermeable Membran (in Fig. 2 nicht dargestellt) angeordnet sein. Die Membran kann sich auch über die gesamte Unterseite des Etiketts erstrecken. Bei untereseitig selbstklebender Ausführung muß die Membran dann im Bereich der Gasaustauschöffnung 3 weitgehend klebstofffrei sein, um ihre Gaspermeabilität zu bewahren. Die Gasdurchtrittsöffnungen 6 sind als Ausstanzungen im Oberetikett 5 ausgeführt. Dadurch, daß Austrittsöffnungen 6 und Gasaustauschöffnung 3 bei bestimmungsgemäßer Anbringung versetzt zueinander angeordnet sind, ist letztere gut geschützt, selbst wenn ein Hochdruckwasserstrahl direkt auf das Etikett gerichtet wird. Die Anordnung der Gasdurchtrittsöffnungen 6 im Oberetikett ist besonders dann vorteilhaft, wenn das Etikett über Kopf angebracht wird, da dann evtl. in der Aussparung 4 des Unteretiketts befindliche Flüssigkeit leicht abfließen kann.

Das in Fig. 3a dargestellt Oberetikett 1 ist als Hinweisschild mit farbigem Aufdruck ausgeführt. Das zugehörige, in Fig. 3b dargestellt Unteretikett 7 weist drei miteinander verbundene Kanäle 5 auf, welche jeweils einen Winkel von ungefähr 120 Grad miteinander einschließen. So ist gewährleistet, daß in fast beliebiger Orientierung des Etiketts im Raum evtl. im Kanalsystem befindliche Flüssigkeit durch die Gasdurchtrittsöffnungen 6 abfließen kann, welche sich wiederum dort befinden, wo die Kanäle 5 an den Etikettenrand reichen. Die mit dem Etikett zu verdeckende Gasaustauschöffnung 3 ist vorteilhafterweise wieder mit einer gaspermeablen Membran (nicht dargestellt) verschlossen, welche vorzugsweise als Teil des Etiketts ausgebildet ist und sich über die ganze oder einen Teil der Etikettenunterseite erstrecken kann. Die Kanäle 5 weisen einen Knick in der Etikettenebene auf. Trifft ein Flüssigkeitshochdruckstrahl neben dem Etikett auf, so erfährt eine eventuell in den Kanal 5 gelangende Flüssigkeitsströmung einen erheblichen Druckverlust. Da übliche semipermeable (d.h. gaspermeable aber unter Normalbedingungen wasserundurchlässige) Membranen ab einem gewissen Mindestflüssigkeitsdruck flüssigkeitsdurchlässig werden, erfüllen diese so noch unter Umgebungsbedingungen ihren Zweck, wo sie ohne erfindungsgemäße Abdeckung bereits versagen würden.

Die Figuren 4b, 5b, 6b und 7b zeigen jeweils alternativ gestaltete Unteretiketten 7 mit unterschiedlichen Anordnungen der Kanäle 5. Die Kanäle 5 sind jeweils in verschiedene Raumrichtungen gerichtet, um das Abfließen von Flüssigkeit bei unterschiedlicher Orientierung des Etiketts zu ermöglichen. Die Kanäle 5 münden jeweils in eine gemeinsame zentrale Aussparung 4, wo sich bei bestimmungsgemäßer Anbringung des Etiketts die abzudeckende Gasaustauschöffnung 3 befindet. Vorteilhafterweise ist diese wiederum durch eine in obigem Sinne semipermeable Membran (nicht dargestellt) verschlossen, welche vorzugsweise als Teil des Etiketts ausgebildet ist und sich über die ganze oder einen Teil der Etikettenunterseite erstrecken kann. Die Gasdurchtrittsöffnungen 6 befinden sich wiederum dort, wo die Kanäle 5 an den Etikettenrand reichen.

Durch verschiedene Maßnahmen wird in den dargestellten Beispielen das Vordringen von Flüssigkeit zur Gasaustauschöffnung 3 erschwert, bzw. der Druckverlust in einer eventuell eintretenden Flüssigkeitsströmung erhöht, um die Membran zu entlasten. In Fig. 5b sind die Kanäle 5 relativ schmal ausgeführt und treffen schräg auf einen Eckbereich der zentralen Ausnehmung 4. Wie anhand des strichliert gezeichneten Pfeils erkennbar, kann selbst ein schräg durch eine Gasdurchtrittsöffnung 6 eintretender scharfer Flüssigkeitsstrahl nicht direkt auf der Gasaustauschöffnung 3 auftreffen.

In Fig. 6b sind die Kanäle 5 sehr lang ausgeführt und knicken um 90 Grad ab. Auch hier ist anhand des strichliert gezeichneten Pfeils erkennbar, daß selbst ein schräg durch eine Gasdurchtrittsöffnung 6 eintretender scharfer Flüssigkeitsstrahl nicht direkt auf der Gasaustauschöffnung 3 auftreffen kann. Gleiches gilt für das Unteretikett 7 in Fig. 7b, bei welcher die jeweilige Mündung der Kanäle 5 in die Umgebung eine Art Prallschutz 13 aufweist, welcher vor schräg auftreffenden scharfen Flüssigkeitsstrahlen oder Fremdkörpern schützt.

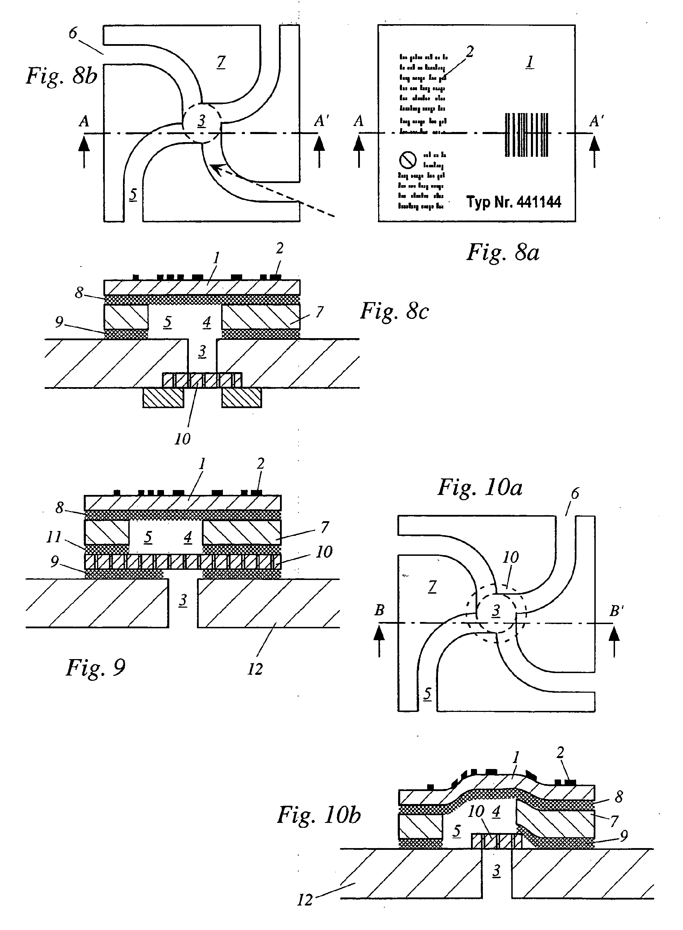

In Fig. 8b weisen die relativ langen und schmalen Kanäle 5 eine Biegung auf, welche demselben Zweck dient.

In Figuren 4a, 5a, 6a, 7a und 8a sind die jeweils zugehörigen Oberetiketten 1 dargestellt. In Fig. 4a ist das Oberetikett als Warnschild ausgeführt, in den Figuren 5a, 6a und 8a als Typenschild. Wie anhand aller dargestellten Oberetiketten 1 ersichtlich ist, bietet die erfindungsgemäße Lösung eine große Bandbreite an Ausführungsmöglichkeiten für zweckgemäße Produktgestaltung. Die Formen der Etiketten müssen, insbesondere wenn diese selbstklebend ausgeführt sind, meist nicht exakt auf vorgegebene Gehäusegeometrien abgestimmt sein. Es ist in der Regel ausreichend, wenn das Etikett im Vergleich mit den Gehäuseabmessungen nicht zu groß und das Kanalsystem des Etiketts in Hinblick auf die abzudeckende Gasaustauschöffnung 3 nicht zu klein ausgeführt ist.

Fig. 8c zeigt einen Schnitt durch das in Figuren 8a und 8b dargestellte Etikett entlag der Schnittlinie A-A', nachdem es mittels einer unterseitigen Haftklebstoffbeschichtung 9 bestimmungsgemäß über eine Gasaustauschöffnung 3 eines Gehäuses eines elektrischen oder elektronischen Geräts geklebt wurde. Die Gehäusewand 12 ist nur ausschnittsweise dargestellt. Bei der abgebildeten Variante ist die Gasaustauschöffnung 3 bereits mit einer Membran 10 versehen, so daß das Etikett ohne Membran ausgeführt sein kann. Oberetikett 1 und Unteretikett 7 sind über die Klebstoffschicht 8 miteinander verklebt.

Bei der in Fig. 9 ebenfalls in Schnittdarstellung abgebildeten Variante ist eine gaspermeable, hydrophobisierte Membran 10 Teil des Etiketts. Sie ist unterseitig außer im Bereich der Gasaustauschöffnung 3 mit Haftklebstoff 9 beschichtet und oberseitig über die Klebstoffschicht 11 mit dem Unteretikett 7 verklebt. Diese Anordnung besitzt den Vorteil, daß Membran 10 und deren Abdeckung in einem Arbeitsgang angebracht werden können.

In den Figuren 10a und 10b ist eine ähnliche Variante abgebildet, wobei sich die Membran 10 nicht über die gesamte Unterseite des Etiketts erstreckt. Das Etikett haftet somit bereits aufgrund der unterseitigen Haftklebstoffbeschichtung 9 des Unteretiketts 7 auf der Gehäusewand 12. Die Membran 10 selbst braucht nicht selbstklebend zu sein. Diese Anordnung besitzt den Vorteil, daß gegenüber der in Fig. 9 abgebildeten Variante Membranmaterial eingespart wird.

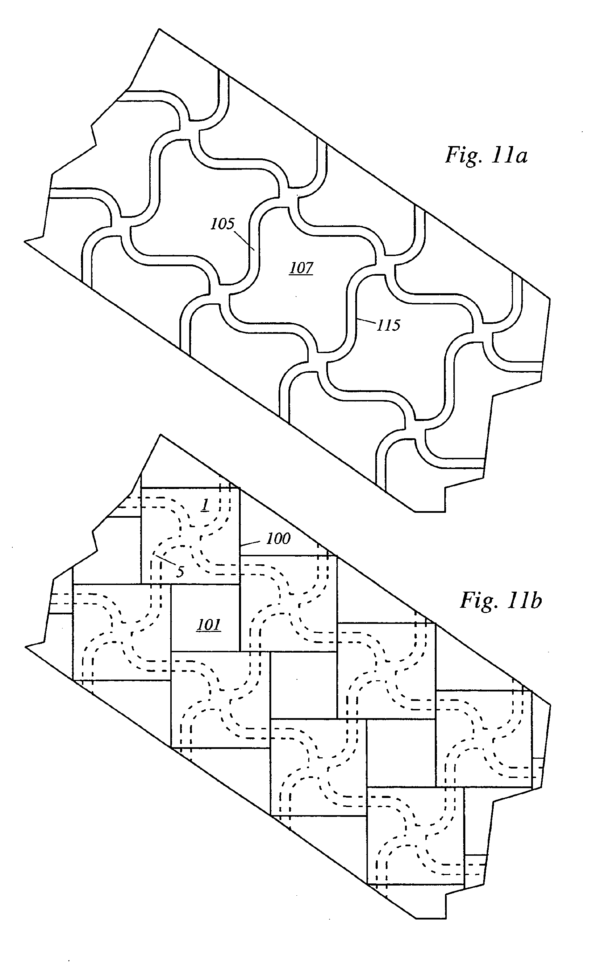

Figuren 11a und 11b verdeutlichen die erfindungsgemäße Herstellung der Kanalstrukturen. In eine unterseitig haftklebstoffbeschichtete und auf einer klebstoffabweisend beschichteten Trägerbahn angeordnete Unteretikettenmaterialbahn 107 werden die Konturen 115 der Kanäle 5 gestanzt und das entstehende Gitter 105 abgezogen. Anschließend wird eine unterseitig ebenfalls haftklebstoffbeschichtete - Oberetikettenmaterialbahn 101 überlaminiert. Die Etikettenkonturen 100 werden gestanzt. Sollen die Etiketten unterseitig eine Membran 10 aufweisen wie in Fig. 9 dargestellt, so wird vor diesem Stanzvorgang eine Bahn aus Membranmaterial unterlaminiert. Für die Herstellung von Etiketten der in Fig. 10a-b dargestellte Art können die Membranen 10 nach dem Gitterabzug auf die selbstklebend beschichtete Unterseite der Unteretikettenmaterialbahn aufgespendet werden.

## Patentansprüche

1. Etikett zum Abdecken von Gasaustauschöffnungen (3), aufweisend
- ein Oberetikett (1) und
- ein Unteretikett (7), welches ein Kanalsystem mit mindestens einem Kanal (5) in Form einer Aussparung aufweist,
wobei das Kanalsystem unterseitig zumindest teilflächig für Gas durchlässig ist und direkt mit mindestens einer im Etikett vorgesehenen Gasdurchtrittsöffnung (6) verbunden ist,
**dadurch gekennzeichnet, daß** das Etikett selbstklebend ausgeführt ist.

2. Etikett gemäß einem der vorangehenden Ansprüche, wobei das Kanalsystem mehr als einen Kanal (5) aufweist und wobei alle Kanäle (5) miteinander verbunden sind.

3. Etikett gemäß einem der vorangehenden Ansprüche, wobei der Kanal (5) in der Ebene des Unteretiketts (7) geknickt oder gekrümmt ist.

4. Etikett gemäß einem der vorangehenden Ansprüche, wobei mindestens drei Kanäle (5) vorgesehen sind.

5. Etikett gemäß Anspruch 4, wobei der größte zwischen zwei benachbarten Kanälen (5) eingeschlossene Winkel in der Ebene des Unteretiketts (7) kleiner als 180 Grad ist.

6. Etikett gemäß einem der vorangehenden Ansprüche, welches ferner eine gaspermeable Membran (10) aufweist.

7. Etikett gemäß Anspruch 6, wobei die Membran (10) hydrophob oder hydrophobisiert ist.

8. Etikett gemäß einem der vorangehenden Ansprüche, wobei das Unteretikett (7) eine Dicke von mindestens 0,3 mm aufweist.

9. Etikett gemäß Anspruch 8, wobei das Unteretikett (7) eine Dicke von mindestens 0,6 mm aufweist.

10. Etikett gemäß einem der vorangehenden Ansprüche, wobei das Unteretikett (7) eine Dicke von höchstens 1 mm aufweist.

11. Etikett gemäß einem der vorangehenden Ansprüche, wobei das Oberetikett (1) mit Text- und/oder Bild- und/oder Code-Information (2) bedruckt ist.

12. Etikett gemäß einem der vorangehenden Ansprüche, wobei das Oberetikett mehrlagig (1) ausgeführt ist.

13. Etikett gemäß einem der vorangehenden Ansprüche, wobei das Oberetikett (1) laserbeschriftbar ist.

14. Etikett gemäß einem der vorangehenden Ansprüche, wobei das Unteretikett (7) mehrlagig ausgeführt ist.

15. Verfahren zum Herstellen von Etiketten mit Kanalstrukturen aufweisendem Unteretikett (7), aufweisend die folgenden Schritte:
(a) Bereitstellen einer Unteretikettenmaterialbahn (107) auf einer klebstoffabweisend beschichteten Trägerbahn,
(b) Stanzen der Kanalstrukturen (105) in Form eines wiederkehrenden, zusammenhängenden Musters,
(c) Abziehen des die Kanalstrukturen (105) füllenden Unteretikettenmaterials als Gitter und
(d) Aufbringen von die Kanalstrukturen (105) überdeckendem Oberetikettenmaterial.

16. Verfahren gemäß Anspruch 15, wobei beim Stanzen der Kanalstrukturen (105) auch die Konturen der Unteretiketten (7) gestanzt, und
das die Kanalstrukturen (105) füllende Unteretikettenmaterial mit dem den Zwischenraum benachbarter Unteretiketten (7) füllendem Unteretikettenmaterial als gemeinsames Gitter abgezogen wird.

17. Verfahren gemäß einem der Ansprüche 15-16, wobei das Aufbringen des Oberetikettenmaterials durch Überlaminieren einer Oberetikettenmaterialbahn (101) erfolgt und nach dem Überlaminieren die Konturen der Etiketten gestanzt werden.

18. Verfahren gemäß Anspruch 16, wobei das Aufbringen des Oberetikettenmaterials durch Aufspenden selbstklebender Oberetiketten (1) erfolgt.

19. Verfahren gemäße einem der Ansprüche 15-18, wobei das Unteretikettenmaterial nach Abziehen des Gitters und vor oder nach Aufbringen des Oberetikettenmaterials unterseitig mit einer Bahn aus gaspermeablem Membranmaterial zusammenlaminiert wird.

## Claims

1. A label for covering gas exchange openings (3), comprising
- a top label (1) and
- a bottom label (7), which has a channel system having at least one channel (5) in the form of a recess,
wherein the channel system is permeable to gas on the bottom over at least a part of its area and is connected to at least one gas passage opening (6) provided in the label,
wherein the label is implemented as self-adhesive.

2. The label according to one of the preceding claims,
wherein the label comprises more than one channel (5) and all channels (5) are connected to one another.

3. The label according to one of the preceding claims,
wherein the channel (5) is kinked or curved in the plane of the bottom label (7).

4. The label according to one of the preceding claims,
wherein at least three channels (5) are provided.

5. The label according to Claim 4,
wherein the largest angle enclosed between two neighboring channels (5) in the plane of the bottom label (7) is smaller than 180°.

6. The label according to one of the preceding claims,
which also comprises a gas permeable membrane (10).

7. The label according to Claim 6,
wherein the membrane (10) is hydrophobic or hydrophobized.

8. The self-adhesive label according to one of the preceding claims,
wherein the bottom label (7) has a thickness of at least 0.3 mm.

9. The self-adhesive label according to Claim 8,
wherein the bottom label (7) has a thickness of at least 0.6 mm.

10. The self-adhesive label according to one of the preceding claims,
wherein the bottom label (7) has a thickness of at most 1 mm.

11. The self-adhesive label according to one of the preceding claims,
wherein the top label (1) is printed with text and/or image and/or code information (2).

12. The self-adhesive label according to one of the preceding claims,
wherein the top label (1) is implemented as multilayered.

13. The self-adhesive label according to one of the preceding claims,
wherein the top label (1) is laser-writable.

14. The self-adhesive label according to one of the preceding claims,
wherein the bottom label (7) is implemented as multilayered.

15. A method for manufacturing labels having a bottom label (7) having channel structures, having the following steps:
(a) providing a bottom label material web (107) on a carrier web coated so that it repels adhesive,
(b) stamping the channel structures (105) in the form of a repeating, coherent pattern,
(c) pulling off the bottom label material which fills the channel structures (105) as a lattice, and
(d) applying top label material which covers the channel structures (105).

16. The method according to Claim 15,
wherein, during stamping of the channel structures (105), the contours of the bottom labels (7) are also stamped, and
the bottom label material which fills the channel structures (105) is pulled off with the bottom label material which fills the intermediate space of neighboring bottom labels (7) as a shared lattice.

17. The method according to one of Claims 15-16,
wherein the top label material is applied by being laminated over a top label material web (101) and, after the lamination, the contours of the labels are stamped.

18. The method according to Claim 16,
wherein the application of the top label material is performed by dispensing self-adhesive top labels (1).

19. The method according to one of Claims 15-18,
wherein the bottom label material is laminated together on the bottom with the web made of gaspermeable membrane material after the lattice is pulled off and before or after the top label material is applied.

## Revendications

1. Etiquette destinée à recouvrir des ouvertures d'échange de gaz (3), comprenant
- une étiquette supérieure (1) et
- une étiquette inférieure (7), laquelle comprend un système de canal doté d'au moins un canal (5) sous forme d'un évidement ;
le système de canal laissant passer le gaz côté inférieur au moins sur une partie de la surface et étant relié directement à au moins une ouverture de passage de gaz (6) prévue dans l'étiquette, **caractérisée en ce que** l'étiquette est réalisée de manière autocollante.

2. Etiquette selon l'une quelconque des revendications précédentes, le système de canal comprenant plus d'un canal (5) et tous les canaux (5) étant reliés les uns aux autres.

3. Etiquette selon l'une quelconque des revendications précédentes, le canal (5) étant coudé ou courbé dans le plan de l'étiquette inférieure (7).

4. Etiquette selon l'une quelconque des revendications précédentes, au moins trois canaux (5) étant prévus.

5. Etiquette selon la revendication 4, le plus grand angle enfermé entre deux canaux voisins (5) dans le plan de l'étiquette inférieure (7) étant inférieur à 180 degrés.

6. Etiquette selon l'une quelconque des revendications précédentes, laquelle comprend en outre une membrane perméable au gaz (10).

7. Etiquette selon la revendication 6, la membrane (10) étant hydrophobe ou rendue hydrophobe.

8. Etiquette selon l'une quelconque des revendications précédentes, l'étiquette inférieure (7) comprenant une épaisseur d'au moins 0,3 mm.

9. Etiquette selon la revendication 8, l'étiquette inférieure (7) comprenant une épaisseur d'au moins 0,6 mm.

10. Etiquette selon l'une quelconque des revendications précédentes, l'étiquette inférieure (7) comprenant une épaisseur d'au maximum 1 mm.

11. Etiquette selon l'une quelconque des revendications précédentes, l'étiquette supérieure (1) étant imprimée avec des informations sous forme de texte et/ou d'image et/ou de code (2).

12. Etiquette selon l'une quelconque des revendications précédentes, l'étiquette supérieure étant réalisée avec plusieurs couches (1).

13. Etiquette selon l'une quelconque des revendications précédentes, l'étiquette supérieure (1) pouvant être marquée au laser.

14. Etiquette selon l'une quelconque des revendications précédentes, l'étiquette inférieure (7) étant réalisée avec plusieurs couches.

15. Procédé de fabrication d'étiquettes dotées d'une étiquette inférieure (7) comprenant des structures de canal, comprenant les étapes suivantes consistant à :
(a) mettre à disposition une bande de matériau d'étiquette inférieure (107) sur une bande de support revêtue repoussant l'adhésif,
(b) découper les structures de canal (105) sous forme d'un motif continu, répétitif,
(c) retirer le matériau d'étiquette inférieure remplissant les structures de canal (105) en tant que grille et
(d) appliquer le matériau d'étiquette supérieure recouvrant les structures de canal (105).

16. Procédé selon la revendication 15, les contours des étiquettes inférieures (7) étant également découpés lors du découpage des structures de canal (105), et
le matériau d'étiquette inférieure remplissant les structures de canal (105) étant retiré avec le matériau d'étiquette inférieure remplissant l'espace intermédiaire des étiquettes inférieures voisines (7) en tant que grille commune.

17. Procédé selon l'une quelconque des revendications 15 à 16, l'application du matériau d'étiquette supérieure s'effectuant par surlaminage d'une bande de matériau d'étiquette supérieure (101) et les contours des étiquettes étant découpés après le surlaminage.

18. Procédé selon la revendication 16, l'application du matériau d'étiquette supérieure s'effectuant par distribution d'étiquettes supérieures autocollantes (1).

19. Procédé selon l'une quelconque des revendications 15 à 18, le matériau d'étiquette inférieure, après le retrait de la grille et avant ou après l'application du matériau d'étiquette supérieure étant laminé côté inférieur conjointement avec une bande de matériau de membrane imperméable au gaz.
